# DEMANDE DE BREVET EUROPEEN

(11) **EP 2 366 949 A1**
(43) Date de publication de la demande: **21.09.2011**
(21) Numéro de dépôt: 11158281.3
(22) Date de dépôt: 15.03.2011
(51) Int. Cl.: F21V 33/00, D06N 3/00, D06N 3/12, H05F 3/02, H05K 1/03, H05K 1/00, H05K 1/09

(54) **Produit textile complexe souple, étanche par une imprégnation à base de matériau élastomère, comportant au moins une piste souple conductrice, et procédé de fabrication d'un tel produit**

(30) Priorité: 16.03.2010 FR 1001046
(71) Demandeur: Barbotin, Jean-Charles, 93170 Bagnolet (FR)
(72) Inventeur: Barbotin, Jean-Charles, 93170 Bagnolet (FR)
(74) Mandataire: Kohn, Philippe

(57) **Abrégé**

L'invention propose un produit textile complexe (6) du type qui comporte au moins une trame textile (5) qui est imprégnée dans un matériau élastomère de manière à être complètement revêtue du matériau élastomère sur ses deux faces, et du type dans lequel le matériau élastomère est choisi parmi les élastomères de silicone, de polyuréthanes, les résines époxy, les résines végétales, et les résines issues de la biomasse, caractérisé en ce qu'il comporte des charges conductrices de l'électricité, qui sont choisies parmi un groupe comportant notamment les poudres de charges métalliques et/ou minérales, la poudre de graphite de carbone, et les nanotubes de carbone, de manière à constituer au moins une piste souple conductrice de l'électricité incluse dans le produit, et en ce que ledit matériau élastomère est non conducteur de l'électricité ou est isolé électriquement desdites charges conductrices de l'électricité.

L'invention propose aussi son procédé de revendication.

## Description

L'invention concerne de manière générale le domaine des produits textiles complexes souples, aussi appelés nappes ou membranes « architecturales » en matériau élastomère comportant une trame textile.

Il est connu de l'homme de l'art de traiter des matériaux fibreux (en particulier des supports tissés ou non-tissés), notamment par imprégnation, au moyen de compositions à base de matériau élastomère.

Ainsi, la demande internationale WO-A1-03/106759 décrit un procédé de revêtement par imprégnation d'une trame textile dite « architecturale » (en particulier d'un tissu de verre) à l'aide d'une composition d'un matériau élastomère de silicone.

Dans ce procédé, la trame textile est enduite par la composition de matériau élastomère.

De même, la demande de brevet internationale WO-2004/013403 décrit la réalisation de membranes silicone « architecturales » obtenues par imprégnation d'un tissu de verre au moyen d'une composition de silicone notamment de type élastomère vulcanisable par hydrosilylation (polyaddition).

La demande de brevet français FR-A-2.751.980 concerne plus particulièrement des compositions silicones vulcanisables à froid réticulant par hydrosilylation ou polyaddition, pour produire un matériau élastomère en couche mince. Ces compositions sont adaptées, entre autres, pour servir de revêtement de protection ou de renfort mécanique de différents substrats en matière textile (supports fibreux, tissés, tricotés ou non tissés).

La plupart des documents de l'art antérieur connus à ce jour concerne plus généralement des matériaux techniques ou produits complexes du type textiles « architecturaux » pour l'industrie automobile, ou des plafonds tendus, ou des toiles de tente, des airbags, etc.

L'invention concerne ainsi un produit textile complexe du type qui comporte au moins une trame textile qui est imprégnée dans un matériau élastomère de manière à être complètement revêtue du matériau élastomère sur ses deux faces, et du type dans lequel le matériau élastomère est choisi parmi les élastomères de silicone, de polyuréthanes, les résines époxy, les résines végétales, et les résines issues de la biomasse.

L'épaisseur d'un tel produit est comprise entre 0,3 mm et 5 mm, de préférence entre 0,4 et 3 mm, et plus particulièrement entre 0,5 mm et 1 mm.

Ce type de produit textile complexe présente l'avantage d'être souple et lavable, ce qui présente un intérêt considérable pour des applications dans les domaines de la maroquinerie, de l'habillement ou de la décoration, lorsque la trame textile imprégnée dans le matériau élastomère est en particulier du type dentelle, taffetas ou organza.

Par trame en textile on entend par exemple une âme en textile, tissé ou non tissé sans zones ajourées (par exemple une toile, un organza ou un taffetas) ou un ouvrage en textile avec des zones ajourées (dentelle ou ouvrage en crochets par exemple), ce textile ayant principalement pour fonction de renforcer mécaniquement le produit complexe, mais pouvant aussi avoir une fonction décorative.

Par exemple, dans le cas d'une dentelle incluse dans un tel produit textile complexe, on obtient non seulement un renfort mécanique du fait de la présence de la dentelle en tant que textile de renfort, mais aussi un effet décoratif, qui est magnifié par la transparence du matériau élastomère.

Par support en textile on entend un assemblage de fibres textiles maintenues ensemble par un entrelacement mécanique, qui sont choisies parmi les fibres de verre, de silice, de métal, de céramique, de carbure de silicium, de carbone, d'aramide, de basalte, les fibres naturelles choisies parmi le coton, la laine, le chanvre, le lin, la soie, les fibres artificielles comme la viscose, les fibres cellulosiques, les fibres synthétiques choisies parmi les polyesters, les polyamides, les polyacryliques, les chlorofibres, les polyoléfines, les caoutchoucs synthétiques, l'alcool polyvinylique (PVA), les aramides, les fluoro-fibres et les phénoliques, et leurs mélanges.

Le matériau élastomère est choisi parmi les élastomères de polyuréthanes, les résines époxy, les résines végétales, et les résines issues de la biomasse.

Par résine végétale on entend une résine naturelle secrétée par certains végétaux dits «résineux», comme les sapins ou les pins.

Par résine issue de la biomasse, on entend une résine issue de l'ensemble des matières organiques (non fossiles) provenant de plantes susceptibles d'une valorisation, et qui sont soumises à une synthèse chimique.

Le matériau élastomère est par exemple un élastomère de silicone, qui comporte au moins un agent fluidifiant choisi parmi les huiles de silicones, les essences C et F, et le produit connu sous l'appellation « WHITE SPIRIT ».

Dans le cas d'un produit textile complexe à base de matériau élastomère de silicone, il est préférable que ce dernier comporte au moins un fluidifiant. La présence de cet agent fluidifiant dans la composition du matériau élastomère a pour effet principal de diminuer considérablement, voire même de supprimer complètement, la présence de bulles dans la masse du produit. Cet effet est d'autant plus marqué, pour une épaisseur donnée et dans la gamme revendiquée.

A titre de matériaux élastomères de silicone utilisables dans le cadre de la présente invention, on citera les élastomères de silicone vulcanisables à chaud (par exemple les polydiméthylsiloxanes linéaires) ou à froid (EVF), par des réactions de polyaddition ou de polycondensation.

La produit textile complexe permet par exemple la réalisation de grands formats, comme par exemple des produits textiles complexes en « nappes » de forme rectangulaire présentant une longueur d'au moins 2000 mm et une largeur d'au moins 1400 mm. Cette possibilité de réaliser des produits de grands formats donne la capacité d'optimiser les découpes à réaliser (imbrication des formes à découper) et de diminuer la quantité de chutes (et donc de matière perdue), ce qui représente une économie non négligeable.

Le produit textile complexe peut aussi comprendre une ou plusieurs substances colorantes choisies parmi les pigments, les colorants, et leurs mélanges.

En l'absence de substances colorantes, le matériau élastomère peut être totalement transparent, ce qui a pour avantage de laisser apparaître complètement, et ceci avec une bonne qualité optique, la trame textile (surtout dans le cas d'un textile de type dentelle à effet essentiellement décoratif) ainsi que les éléments végétaux (par exemple pétales etc.) à effet décoratif lorsqu'ils sont présents.

Par contre, pour certaines applications (notamment la maroquinerie ou la décoration), l'ajout de substances colorantes opacifiantes dans la composition du matériau élastomère présente un intérêt lorsque l'on souhaite disposer d'un produit textile complexe complètement opaque.

Par pigment, on entend toute substance colorante se présentant sous forme pulvérulente, qu'elle soit d'origine chimique (c'est-à-dire par synthèse), minérale ou naturelle. Les pigments sont connus pour être plutôt opacifiants.

Par colorant, on entend toute substance colorante se présentant sous forme essentiellement fluide, de préférence liquide, qu'elle soit d'origine chimique (c'est-à-dire par synthèse), minérale ou naturelle. Les colorants sont connus pour être plutôt non opacifiants.

La (ou les) substance(s) colorante(s) peut (ou peuvent) être choisie(s) parmi les pigments ou les colorants traditionnels, les pigments ou les colorants techniques, et leurs mélanges.

Par pigment ou colorant traditionnel, on entend toute substance colorante qui apporte une teinte translucide ou opaque à une matière donnée, sans conférer de propriété particulière à cette matière autre que la coloration dans la masse.

Par opposition, on entend par pigment « technique » tout pigment dont la couleur peut varier en fonction de différents facteurs. Ainsi, à titre de pigments techniques, on citera en particulier les pigments photo-luminescents, les pigments phosphorescents, les pigments fluorescents, les nacres (ou pigments interférentiels) et les pigments thermo-chromiques.

Ainsi, une dentelle incluse avec un pigment thermo-chromique et un pigment photo-luminescent change de couleur en fonction de son environnement thermique, puis s'illumine dans l'obscurité ou la pénombre en laissant apparaître le dessin de la dentelle.

Le produit textile complexe peut en outre comprendre des éléments de texturation, tels que des fils de laine (par exemple d'angora), du tulle plié et recoupé, du voilage non tissé, des copeaux de bois, ou des particules de textile.

Par particules de textile, on entend des fibres textiles de très faible longueur, 3 ou 4 mm, ou de très petits morceaux de textile.

Les possibilités pour le produit textile complexe texturé selon sont aussi très nombreuses.

Par exemple, on utilisera en particulier une laine angora, qui est une laine très charnue en fils, qui permet de faire ressortir quelques fils du matériau élastomère, ce qui procure un relief de la nappe et un toucher plus doux. En outre, le matériau élastomère permet de conserver l'aspect flou de l'angora.

Un autre exemple consiste à insérer du tulle plié manuellement sous forme de bandes, qui une fois imprégnées dans le matériau élastomère ressortiront de la surface du produit de manière aléatoire.

Le produit textile complexe peut en outre comprendre des éléments végétaux, dans un but essentiellement décoratif. A la différence des éléments de texturation, les éléments végétaux ne modifient pas les reliefs du produit.

A titre de végétaux utilisables, on peut notamment citer les pétales de crocus, de bleuet, d'oeillets, le safran, les feuilles (et plus particulièrement leurs nervures), les graines de cumin ou autres.

La trame textile imprégnée dans le matériau élastomère est un support textile, qui peut notamment être choisi parmi les textiles tissés ou non-tissés, essentiellement sans zones ajourées (par exemple une toile, un taffetas, un organza ou de la soie) et les ouvrages textiles présentant des zones pleines et des zones ajourées disposées en motifs décoratifs du type dentelle par exemple ou ouvrages en crochets.

Dans le cas d'une trame textile du type dentelle, cette dernière présente des propriétés liées au matériau élastomère, tout en conservant la délicatesse de l'ouvrage : la dentelle enveloppée d'une fine couche de matériau élastomère devient un textile à la fois résistant et souple, tout étant magnifiée et mise en valeur (précision du travail de tissage). En effet, la dentelle est posée à plat et est légèrement «tenue» pour que le matériau élastomère transparent puisse recouvrir tous les orifices du tissage, afin d'unifier la surface et crée un ensemble solidaire.

La trame, ou support, textile est un assemblage de fibres textiles (maintenues ensemble par un entrelacement mécanique), qui peuvent être avantageusement choisies parmi les fibres de verre, de silice, de métal, de céramique, de carbure de silicium, de carbone, d'aramide, de basalte, les fibres naturelles choisies parmi le coton, la laine, le chanvre, le lin, la soie, les fibres artificielles comme la viscose, les fibres cellulosiques, les fibres synthétiques choisies parmi les polyesters, les polyamides, les polyacryliques, les chlorofibres, les polyoléfines, les caoutchoucs synthétiques, l'alcool polyvinylique (PVA), les aramides, les fluoro-fibres et les phénoliques, et leurs mélanges.

De manière préférée, la trame textile de la nappe est un organza ou un taffetas.

Par taffetas, on entend une étoffe de soie, de rayonne ou de nylon tissée comme de la toile.

Par organza, on entend un tissu fin, à armure unie, fait de soie, de nylon, d'acrylique, ou de polyester.

Dans le produit textile complexe, le matériau élastomère garde intacte toute matière qui y est incluse, qu'il s'agisse de la trame textile ou des éléments végétaux décoratifs, ou encore des éléments de texturation cités précédemment.

Le produit textile complexe est suffisamment souple (malgré la matière incluse) pour rendre un assemblage possible en couture ou par collage. Comme en outre le produit n'est pas thermo-déformable, la découpe des pièces à assembler est réalisable par un outillage mécanique, ou par découpe au laser ou au jet d'eau.

Le produit peut donc être utilisé dans les domaines de la chaussure, de la maroquinerie, la haute-couture, les accessoires de mode ou de décoration d'intérieur, dans l'art de la table, l'ameublement, aussi bien que les domaines des textiles techniques ou encore dits intelligents (c'est-à-dire des textiles ayant des propriétés fonctionnelles spécifiques qui sont adaptées à certains usages particuliers.

Il est connu d'insérer des charges conductrices de l'électricité dans des « nappes » en matériau élastomère. Mais de tels produits sont trop fragiles et se déchirent facilement.

Afin de remédier à cet inconvénient, l'invention propose un produit textile complexe du type mentionné précédemment caractérisé en ce qu'il comporte des charges conductrices de l'électricité de manière à constituer au moins une piste souple conductrice de l'électricité incluse dans le produit.

Conformément à la présente invention, le produit textile complexe en matériau élastomère est texturé avec un textile (par exemple avec un textile tissé de type organza de polyester, nylon, coton, tissé de verre, ou un taffetas), et sa résistance au déchirement augmente considérablement. La partie du produit selon l'invention qui est conductrice de l'électricité est intimement liée au textile « structurant » et le produit textile complexe ainsi structuré et conducteur de l'électricité qui en découle est souple et lavable.

Les domaines d'applications de ces produits textiles complexes conducteurs de l'électricité selon l'invention varient en fonction du degré de couverture (partielle ou totale) de la trame textile par le matériau élastomère (rendu conducteur de l'électricité par l'introduction dans sa composition de charges conductrices de l'électricité).

Dans le cas d'une couverture complète de la trame textile par le produit conducteur de l'électricité, le produit textile complexe ainsi formé peut servir de capteur ou d'anode ou cathode pour un clavier tactile, une dalle souple d'écran, un capteur solaire, ou un dissipateur de charges textile antistatique.

Selon d'autres caractéristiques du produit textile selon l'invention :
- lesdites charges conductrices de l'électricité appartiennent à un mélange constituant une résine, notamment élastomère, conductrice de l'électricité ;
- le produit comporte au moins un composant électrique et/ou électronique inclus dans l'épaisseur du produit et qui est connecté électriquement à ladite au moins une piste conductrice pour constituer un élément de circuit électrique et/ou électronique souple inclus dans le produit textile complexe.

Dans le cas d'une couverture partielle de la trame textile par le produit conducteur de l'électricité, cette couverture peut par exemple se présenter sous forme d'un circuit électronique et/ou électrique permettant d'alimenter des points d'éclairage, des écrans, des micro-moteurs, des capteurs de température ou de pression, ou tout autre type de capteur apte à capter des changements du milieu environnant, ou des actionneurs divers qui, une fois montés ensemble, permettent de réaliser un produit fini ultra souple.

Ces produits textiles complexes texturés et conducteurs de l'électricité conformes à la présente invention peuvent être utilisés dans différents domaines d'application : en particulier dans le domaine dit du textile « technique » (l'habillement professionnel, la plongée, la combinaison de pilote et spatiale), l'automobile, l'aéronautique, le milieu aquatique, le ferroviaire, l'audiovisuel, l'industrie chimique, la mode, le sport, le design industriel, le milieu médical.

Un tel produit textile complexe est recyclable, dans la mesure où il peut être déposé dans des décharges d'ordures ménagères, et ce, sans conséquence pour l'environnement. Toutefois, l'incinération contrôlée, appelée recyclage thermique, est recommandée. La chaleur résiduelle peut ainsi être récupérée pour générer des sous-produits naturels tels que l'acide salicylique, l'acide carbonique et l'eau. Dans le cas où l'on utilise des élastomères de silicone, ceux-ci, une fois broyés, peuvent être utilisés (recyclés) comme charges pour la réalisation de nouveaux élastomères.

La présente invention a également pour objet un procédé de fabrication d'un produit textile complexe du type comportant au moins une trame textile qui est imprégnée dans un matériau élastomère de manière à être complètement revêtue du matériau élastomère sur ses deux faces, procédé comprenant les étapes consécutives suivantes :
0) dépôt, partiel ou total, sur l'une au moins des faces de ladite trame textile, d'une composition de résine, notamment élastomère, conductrice de l'électricité comportant des charges conductrices de l'électricité de manière à constituer au moins une piste souple conductrice de l'électricité incluse dans le produit textile complexe ;
   A) application sur une surface plane de coulée d'une composition fluide d'un matériau élastomère pour former une couche (3) de matériau élastomère ;
   B) dépôt, sur ladite couche de matériau élastomère avant qu'elle ne se gélifie, de ladite trame textile ;
   C) raclage pour imprégner ladite trame textile dans la couche de matériau élastomère jusqu'à ce que les deux faces opposées de cette trame soient complètement revêtues du matériau élastomère.

Selon d'autres caractéristiques du procédé :
- il comporte une étape supplémentaire D) d'étuvage du produit textile à une température comprise entre 50°C et 150°C ;
- l'étape 0) de dépôt est réalisée par extrusion, enduction, sérigraphie, ennoblissement, sérigraphie, flexographie ou à l'aide d'une imprimante numérique, notamment du type à jet d'encre ;
- lesdites charges conductrices de l'électricité sont choisies parmi un groupe comportant notamment les poudres de charges métalliques et/ou minérales, la poudre de graphite de carbone, et les nanotubes de carbone ;
- l'étape 0) de dépôt consiste à former au moins une piste conductrice de l'électricité avec deux extrémités et le procédé comporte de plus une étape F) de raccordement de chacune des extrémités de ladite piste conductrice à des fils électriques par une soudure chimique, notamment à l'aide de la composition de résine élastomère conductrice de l'électricité, et en ce que ledit matériau élastomère est non conducteur de l'électricité ou est isolé électriquement desdites charges conductrices de l'électricité ;
- préalablement à l'étape 0) de dépôt de la composition de résine conductrice de l'électricité, au moins un composant électrique et/ou électronique est déposé sur ladite trame textile, et en ce que ladite composition de résine élastomère conductrice de l'électricité est reliée électriquement audit composant pour constituer un élément de circuit électrique et/ou électronique souple inclus dans le produit textile complexe ;
- la surface de coulée est un tapis roulant, sur lequel est appliquée la composition fluide de matériau élastomère de sorte que ledit procédé est continu.

Bien que plane, la surface de coulée sur laquelle on applique, lors de l'étape A, la composition de matériau élastomère, peut présenter des variations du type à légère texturation ou des motifs en relief (par exemple avec des vaguelettes), ou bien être brillante ou mate.

Si la surface est brillante, le produit textile complexe ainsi formé sera aussi brillant. Par contre, si elle est mate, le produit formé sera mat. En effet, les matériaux employés pour réaliser les produits selon l'invention ont des capacités de mimétisme de l'aspect de la surface sur laquelle ils sont coulés.

Dans le cas d'un matériau élastomère de silicone, il est préférable que ce dernier comporte aussi au moins un fluidifiant. La présence de cet agent fluidifiant dans la composition du matériau élastomère permet l'obtention d'une composition de matériau élastomère plus fluide, dont la viscosité permet un écoulement de la composition tel qu'il conduit à la formation d'une couche d'épaisseur sensiblement constante sur un plan horizontal de grande surface, tout en en maîtrisant la tension de surface.

En d'autres termes, la présence de cet agent fluidifiant permet notamment de limiter l'épaisseur de couche de matériau élastomère formée à celle souhaitée, ainsi que de retenir la composition de matériau élastomère dans son écoulement sur les bords du plan horizontal, ce qui permet de supprimer la nécessité d'un rebord au plan horizontal.

En outre, la présence de cet agent fluidifiant permet également un dégazage plus rapide de la couche de composition de matériau élastomère une fois étalée et avant qu'elle ne se gélifie.

De manière avantageuse, l'étape de dépôt de la trame textile sur la couche de matériau élastomère est précédée d'une étape d'homogénéisation de son épaisseur, par exemple à l'aide d'une racle ou de couteaux.

Afin de réaliser une couche de composition élastomère d'épaisseur sensiblement uniforme (épaisseur de l'ordre de 0,4 mm ± 0,3 mm), il faut, pour former une nappe de 1 m², environ 350g de composition élastomère (avec fluidifiant).

La surface de coulée est par exemple un tapis roulant sur lequel est appliquée la composition du fluide de matériau élastomère, et l'étuvage est réalisé dans une enceinte de chauffage de type tunnel ouvert, au travers duquel le produit textile complexe formé à l'issue de l'étape C est transporté par ledit tapis roulant, de sorte que ledit procédé est continu en permettant ainsi d'augmenter la cadence de production.

L'étape de dépôt est réalisée par extrusion, enduction, ennoblissement, sérigraphie, flexographie ou à l'aide d'une imprimante 3D, ou d'une imprimante du type à jet d'encre, ou encore d'une imprimante à commande numérique trois axes avec des solutions de dosage de fluides.

L'invention sera mieux comprise et d'autres particularités et avantages apparaîtront à la lecture de la description détaillée qui va suivre, la description faisant référence aux dessins annexés dans lesquels :
- la figure 1A représente schématiquement les principales étapes du procédé de fabrication d'une nappe dite architecturale en matériau élastomère ;
- la figure 1B représente schématiquement l'installation permettant au procédé illustré sur la figure 1A de fonctionner de façon continue ;
- la figure 2 représente une succession de vues de dessus de différents produits en forme de nappes architecturales en matériau élastomère de silicone, montrant les effets au niveau du débullage de la présence d'un agent fluidifiant dans la composition du matériau élastomère, de l'épaisseur de la nappe, ainsi que de la présence d'une trame en tissu ;
- la figure 3A représente une vue de dessus d'une nappe architecturale conductrice de l'électricité ne comportant pas de trame textile ;
- la figure 3B représente une vue de dessus d'une nappe architecturale conductrice de l'électricité selon l'invention réalisée conformément au procédé illustré à la figure 1, ce produit textile complexe selon l'invention se différenciant de celui représenté à la figure 3A par la présence de la trame textile ;
- la figure 4A représente schématiquement les mêmes principales étapes du procédé illustré à la figure 1, auxquelles ont été ajoutées des étapes pour inclure des éléments de texturation ou des éléments végétaux de décoration ;
- la figure 4B représente une vue de dessus d'une nappe architecturale en élastomère de silicone selon l'invention, comportant des éléments végétaux ;
- la figure 4C représente une vue de dessus d'une nappe architecturale en matériau élastomère de silicone, comportant des fils de laine angora ;
- la figure 5 représente schématiquement les principales étapes d'un procédé de fabrication d'une nappe architecturale conductrice de l'électricité formant une résistance souple ;
- la figure 6 représente une vue de dessus de la résistance souple obtenue par le procédé illustré à la figure 5 ;
- la figure 7 représente schématiquement les principales étapes d'un procédé de production d'une nappe architecturale conductrice de l'électricité formant un montage ultra souple de diodes électroluminescentes ou LED(s) ;
- la figure 8 représente une vue de dessus du montage ultra souple de LED obtenu par le procédé illustré à la figure 7.

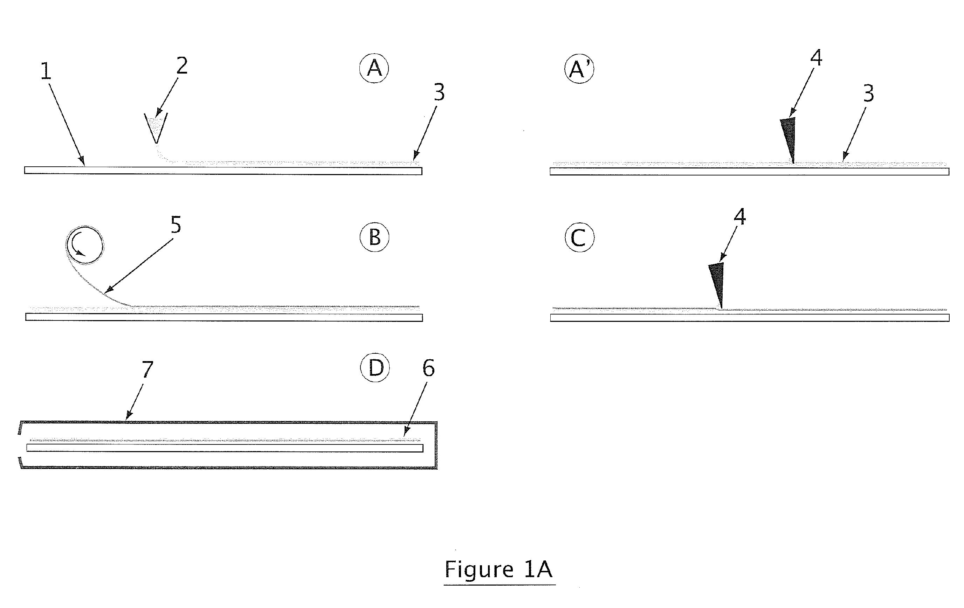

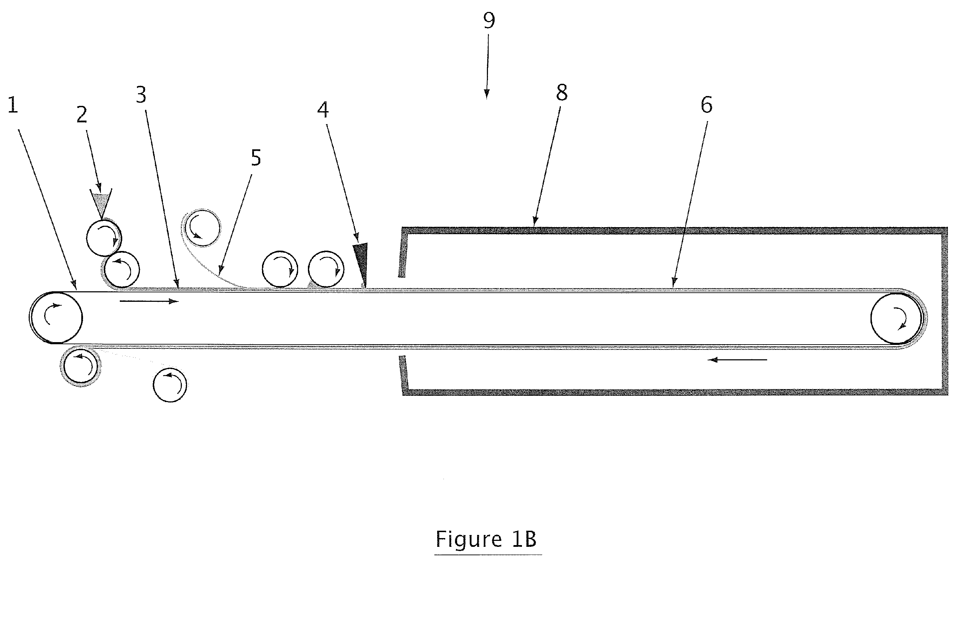

Les éléments identiques représentés sur les figures 1 à 8 sont désignés par des références numériques identiques.

A la figure 1, on a représenté de manière schématique les principales étapes du procédé selon l'invention de fabrication d'un produit textile complexe, ici sous la forme d'une nappe architecturale, 6 en matériau élastomère, comportant les étapes suivantes :
A) application sur une surface plane de coulée 1, ici sous la forme de la face supérieure d'un plan de travail horizontal, d'une composition 2 fluide de matériau élastomère, pour former une couche 3 de matériau élastomère ;
A') homogénéisation de l'épaisseur de la couche 3 par raclage à l'aide de couteaux de calibrage ou d'une racle 4.
B) dépôt, sur ladite couche 3 de matériau élastomère, avant qu'elle ne se gélifie, d'une trame textile 5 ;
C) raclage, également à l'aide de couteaux de calibrage ou d'une racle 4, pour imprégner ladite trame 5 dans la couche 3 de matériau élastomère jusqu'à ce que les deux faces de ladite trame 5 soient complètement enduites de matériau élastomère, et obtenir ainsi une nappe architecturale en matériau élastomère 6 dans laquelle la trame textile est « noyée » et est totalement enrobée par le matériau élastomère qui recouvre complètement les deux faces opposées de la trame textile ;
D) chauffage, par exemple par étuvage, de la nappe architecturale en élastomère 6 dans un four 7 à une température comprise entre 50°C et 150°C, cette étape étant facultative et la réticulation pouvant se produire à température ambiante.

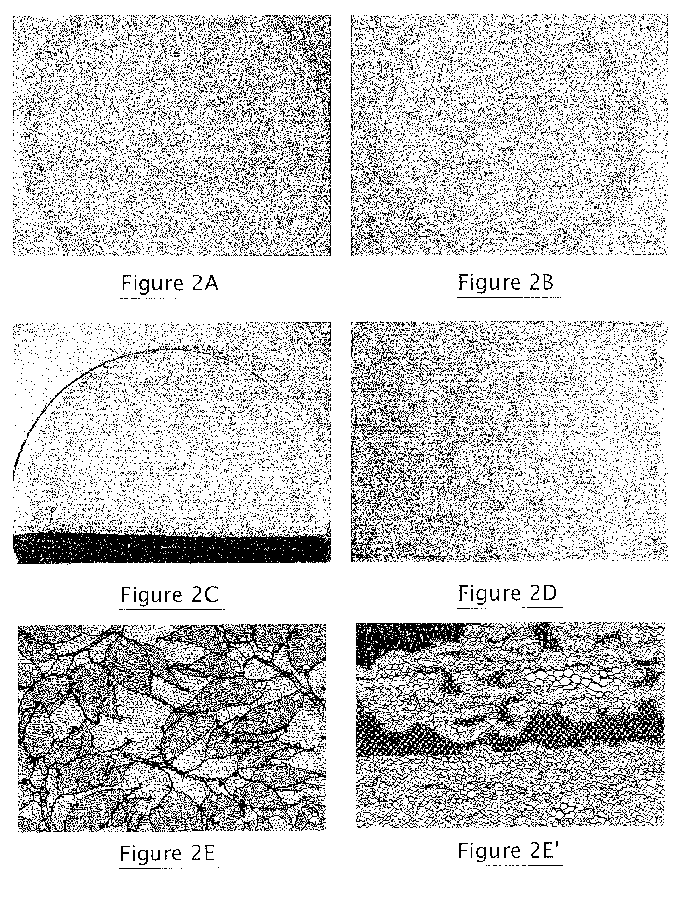

La figure 2 illustre différentes vues de dessus de nappes architecturales en matériau élastomère de silicone montrant respectivement les effets, au niveau du débullage, du fait de la présence d'un agent fluidifiant dans la composition fluide du matériau élastomère, de l'épaisseur de la nappe, ainsi que de la présence d'une trame textile en tissu.

La figure 2A illustre une nappe sans trame textile de 7 mm d'épaisseur pour laquelle on n'a pas ajouté d'agent ou produit fluidifiant dans la composition du matériau élastomère.

La figure 2B montre une nappe sans trame textile de 7 mm d'épaisseur, pour laquelle on a ajouté un fluidifiant dans la composition du matériau élastomère. Ces nappes sont plus épaisses que les nappes selon l'invention dont l'épaisseur est au plus de 5 mm.

La figure 2C montre une nappe sans trame textile, de 2 mm d'épaisseur, pour laquelle on a ajouté un agent ou produit fluidifiant dans la composition du matériau élastomère. Cette nappe présente une épaisseur dans la gamme revendiquée.

La figure 2D montre une nappe avec une trame textile et ayant une épaisseur de 2 mm, pour laquelle on n'a pas ajouté de produit fluidifiant dans la composition du matériau élastomère.

Les figures 2E et 2E' montrent chacune une nappe avec une trame textile (ici de la dentelle) et ayant une épaisseur de 2 mm, pour laquelle on a ajouté un agent fluidifiant dans la composition du matériau élastomère utilisé pour l'imprégnation et l'enrobage de la trame textile.

La comparaison des figures 2A et 2B montre l'effet de l'agent fluidifiant sur le débullage de la couche de matériau élastomère 3, qui est plus important avec l'agent fluidifiant.

La comparaison des figures 2B et 2C montre l'effet de l'épaisseur sur ce même paramètre : plus l'épaisseur de la matière est faible, plus le débullage avec fluidifiant est facile.

La comparaison entre d'une part les figures 2D et d'autre part le figures 2E et 2E' montre aussi l'effet de l'agent fluidifiant sur le débullage de la couche de matériau élastomère 3, en présence cette fois ci d'une trame textile : cet effet est encore accentué en présence de la trame textile dans la mesure dans laquelle on observe une absence complète de bulles sur les figures 2E et 2E'.

Si l'on souhaite ajouter des pigments ou des charges conductrices de l'électricité dans la composition du matériau élastomère, ceux-ci sont mélangés préalablement à l'étape A, lors de la préparation de la composition de matériau élastomère 2.

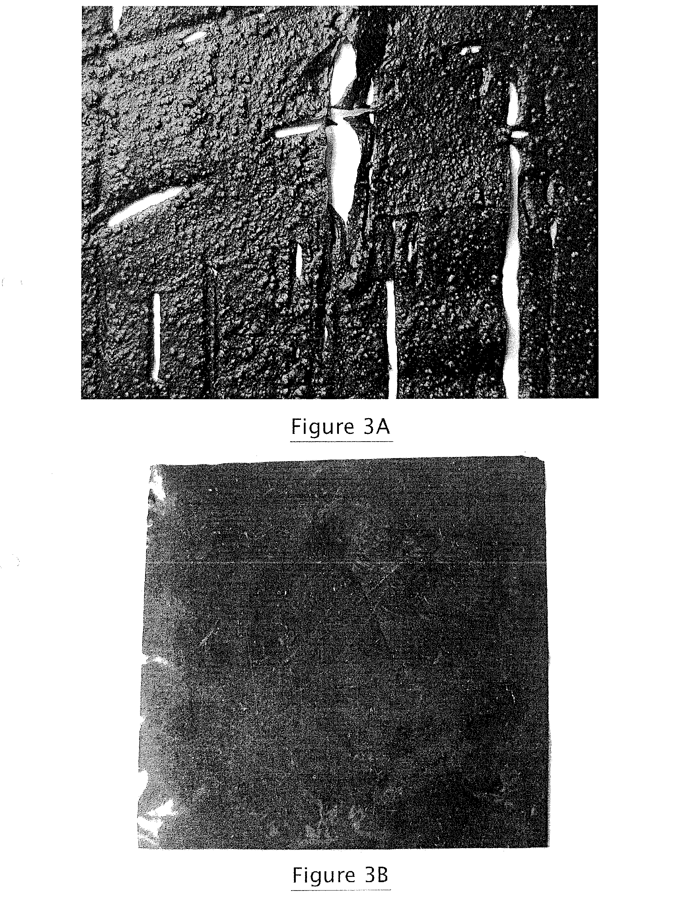

Ainsi dans le cas où l'on ajoute des charges conductrices de l'électricité (telles que définies précédemment) à la composition du matériau élastomère (c'est-à-dire préalablement à l'étape A), la nappe entière ainsi formée est complètement conductrice de l'électricité. Selon que la nappe comprend, ou non, une trame textile, la résistance au déchirement de cette nappe est différente, comme cela est illustré par la comparaison des figures 3A et 3B.

La figure 3A représente une vue de dessus d'une nappe architecturale conductrice de l'électricité ne comportant pas de trame textile, tandis que la figure 3B représente une vue de dessus d'une nappe architecturale conductrice de l'électricité réalisée conformément au procédé selon l'invention représentée sur la figure 1, cette nappe se différenciant de celle illustrée à la figure 3A par la présence de la trame textile.

On a étudié le comportement de ces deux nappes lors d'un test de déchirement manuel (par traction). La nappe selon l'invention représentée à la figure 3B ne se déchire quasiment pas et reste souple, tandis que celle représentée à la figure 3A présente des zones de déchirement importantes, à la fois sur ses bords, mais aussi au milieu de la nappe.

A la figure 1B, on a représenté schématiquement une installation 9 permettant au procédé illustré à la figure 1A d'être mis en oeuvre pour une production en continu. Dans cette installation 9, la surface de coulée 1 est un tapis roulant, sur lequel est appliquée / déposée la composition fluide de matériau élastomère 2, et l'étuvage est réalisé dans une enceinte de chauffage 8 de type tunnel ouvert, au travers duquel la nappe architecturale 6 formée à l'issue de l'étape C) est transportée par le tapis roulant 1.

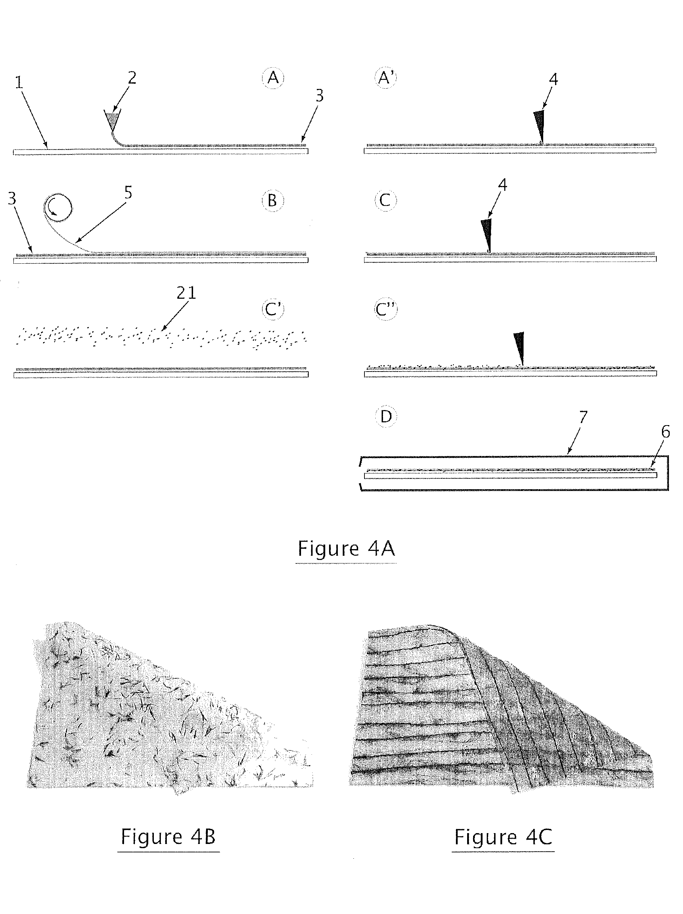

Le procédé illustré à la figure 4A comporte les mêmes étapes principales que celui représenté sur la figure 1, mais il comporte en outre des étapes (étapes C' et C" de raclage) permettant d'inclure des éléments 21 de texturation ou des éléments végétaux de décoration.

Les figures 4B et 4C sont deux vues de dessus de nappes obtenues selon le procédé illustré à la figure 4A, l'une (figure 4B) comportant des végétaux et l'autre (figure 4C) des fils de laine Angora.

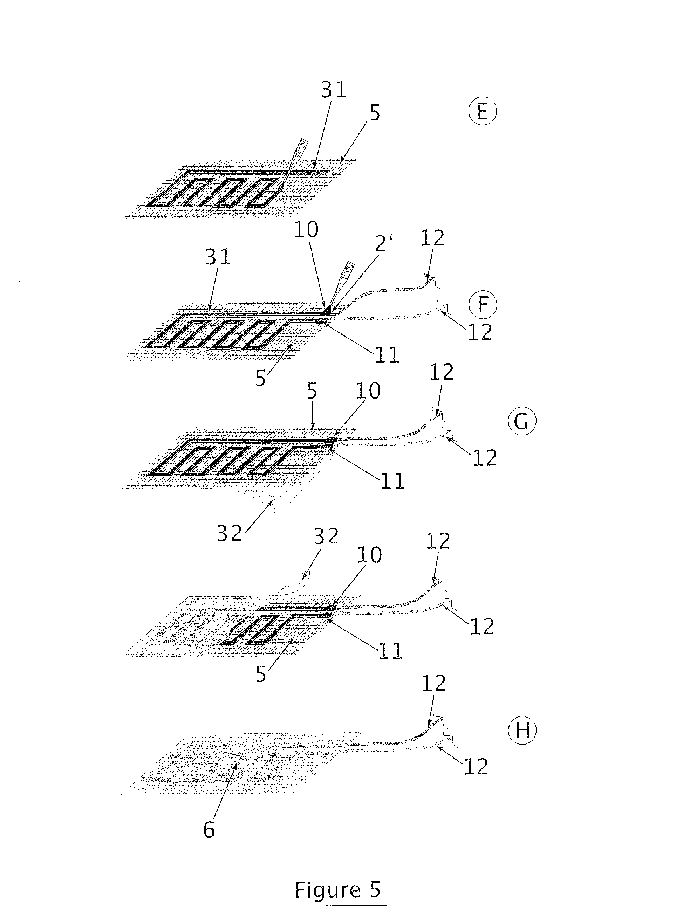

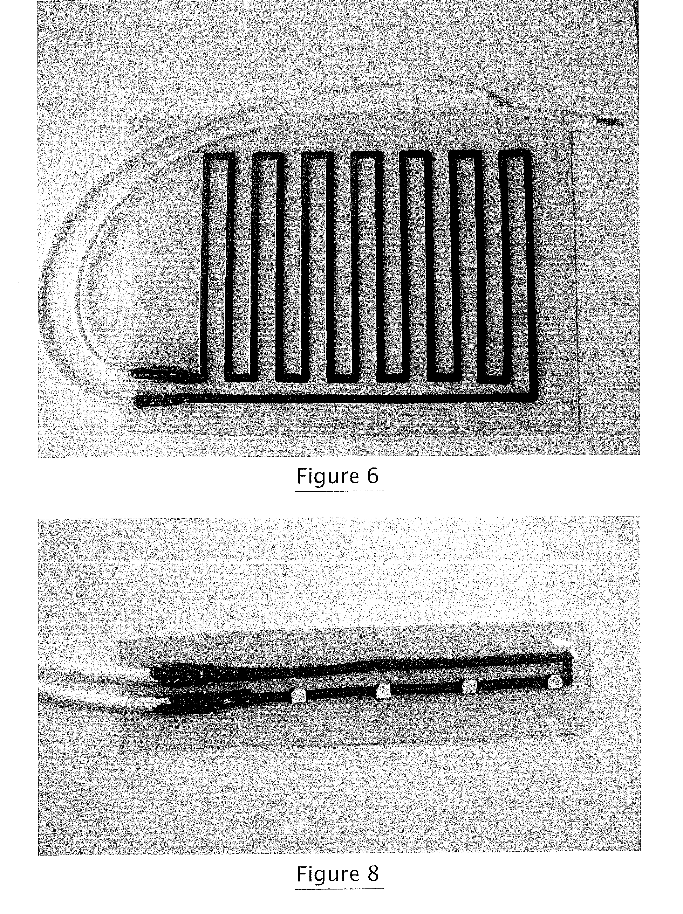

La figure 5 représente schématiquement les principales étapes d'un exemple d'un procédé selon l'invention de production d'une nappe architecturale conductrice de l'électricité constituant par exemple une résistance électrique souple, et la figure 6 représente une vue de dessus de la résistance électrique souple obtenue par le procédé représenté à la figure 5.

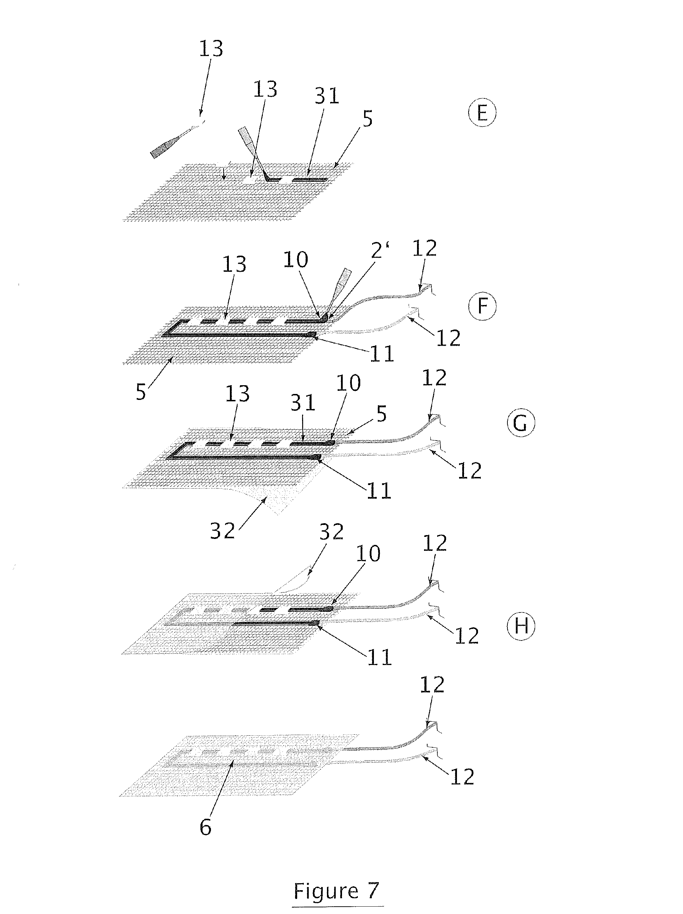

La figure 7 représente schématiquement les principales étapes d'un exemple d'un procédé selon l'invention de production d'une nappe architecturale conductrice de l'électricité formant un montage ultra souple de LEDs, et la figure 8 représente une vue de dessus du montage ultra souple obtenu par le procédé illustré à la figure 7.

Les procédés représentés aux figures 5 et 7 représentent les différentes étapes de fabrication d'une nappe architecturale conductrice de l'électricité, comprenant une étape 0) de dépôt, ici partiel, sur l'une des faces d'une trame textile 5, d'une composition 2' d'une résine élastomère conductrice de l'électricité comportant une ou plusieurs charges conductrices de l'électricité telles que définies précédemment.

Dans le cas du procédé représenté à la figure 5, l'étape de dépôt de la composition 2' de la résine élastomère conductrice de l'électricité est un dépôt partiel consistant à former au moins un élément ou tronçon de circuit 31 conducteur de l'électricité, ici sous la forme d'une piste conductrice de l'électricité avec deux extrémités 10 et 11.

On réalise ensuite les étapes suivantes :
F) raccordement de chacune des extrémités 10, 11 de la piste 31 du circuit à un fil électrique associé 12, par exemple par une soudure chimique à l'aide de la composition 2' de résine élastomère conductrice de l'électricité ;
G) application, sur chacune des faces de la trame 5 textile, d'une composition fluide 32 de matériau élastomère non conductrice de l'électricité, de manière à enrober complètement la trame textile 5 et son ou ses élément(s) de circuit(s) électrique(s).

De manière optionnelle, une étape H) d'étuvage à une température comprise entre 50°C et 150°C peut être prévue.

La nappe architecturale conductrice de l'électricité 6 ainsi obtenue constitue une résistance souple et étanche.

Le procédé illustré à la figure 7 est quasiment identique à celui de la figure 5, à la différence qu'il comporte en outre les étapes suivantes :
- préalablement à l'étape de dépôt de la composition de résine élastomère conductrice de l'électricité 2', plusieurs composants électriques ou électroniques tels que par exemple des diodes LED 13 sont fixés, par exemple collés, sur la trame textile 5 en étant espacés les uns par rapport aux autres ; et
- la composition 2' de résine élastomère conductrice de l'électricité est déposée sur la trame textile 5 au cours de l'étape de dépôt, de manière à former un circuit 31, composés de pistes conductrices de l'électricité reliant électriquement chacune des diodes LED 13, de sorte que la nappe architecturale conductrice de l'électricité 6 ainsi obtenue constitue ici un montage de LEDs ultra souple et étanche.

Dans le type de circuits réalisés conformément à l'invention et intégrés dans un produit textile complexe selon l'invention, on peut intégrer des composants électroniques traditionnels ou CMS. Les composants électroniques sont intégrés au circuit avec des soudures chimiques (par une colle à base de matériau élastomère conducteur de l'électricité) qui font la liaison électrique avec les pistes conductrices du circuit et l'ensemble devient solidaire et ultra souple.

On peut aussi envisager le développement de composants électroniques polymères sur le même principe que la résine conductrice de l'électricité. Ce qui permet de donner naissance a toute une gamme de résines à base de matériau élastomère avec des propriétés électriques et/ou électroniques propres.

Ceci a pour objectif de remplacer les composants traditionnels rigides par des composants monomères ou polymères liquides ou gélatineux, qui, après réticulation deviennent des matériaux ou produits en matériau(x) élastomère(s) souples et/ou mous. Il est ainsi aussi possible de développer des composants préformés en matériau élastomère.

A cet effet, il existe par exemple des résines qui, sous l'augmentation de la tension électrique, provoquent une rupture de courant (phénomène appeler frittage) et d'autres résines qui peuvent servir de résistance électrique.

Les applications possibles de ce type de transformations seront différentes en fonction d'une application partielle ou totale sur le support textile.

Un circuit électronique en résine électro-conductrice sur trame textile est totalement enduit/encapsulé, et il permet de disposer d'un produit extrêmement souple, inoxydable, résistant aux rayons UV, résistant aux mouvements, d'une tenue thermique de -20°C à 280°C environ, étanche et translucide, voire même transparent.

Le matériau élastomère utilisé pour l'enrobage a une qualité optique sans dégagement de solvant pendant sa mise en oeuvre et son utilisation.

Le matériau élastomère accepte une auto-cicatrisation mutuelle pour ne pas avoir d'incompatibilité chimique, avoir une liaison de surface parfaite et ne pas avoir, dans le temps, un délaminage des différentes couches et éléments constitutifs.

La trame textile intégrée renforce le matériau élastomère d'imprégnation contre les risques de déchirement, la résine de matériau élastomère électro-conducteur étant un matériau d'une résistance insuffisante aux déchirements trop fragile pour l'utiliser sans un substrat. Il est donc particulièrement avantageux d'imprégner ou enduire un textile, par exemple de type organza afin d'en augmenter la résistance, tout en conservant la souplesse. La partie conductrice est ainsi liée à la trame textile de manière intime et l'ensemble reste souple.

## Revendications

1. Produit textile complexe (6) du type qui comporte au moins une trame textile (5) qui est imprégnée dans un matériau élastomère de manière à être complètement revêtue du matériau élastomère sur ses deux faces, et du type dans lequel le matériau élastomère est choisi parmi les élastomères de silicone, de polyuréthanes, les résines époxy, les résines végétales, et les résines issues de la biomasse,
**caractérisé en ce qu'**il comporte des charges conductrices de l'électricité, de manière à constituer au moins une piste souple conductrice de l'électricité incluse dans le produit.

2. Produit textile complexe selon la revendication 1, **caractérisé en ce que** lesdites charges conductrices de l'électricité appartiennent à un mélange constituant une résine, notamment élastomère, conductrice de l'électricité.

3. Produit textile complexe selon l'une quelconque des revendications précédentes, **caractérisé en ce qu'**il comporte au moins un composant électrique et/ou électronique inclus dans l'épaisseur du produit et qui est connecté électriquement à ladite au moins une piste conductrice pour constituer un élément de circuit électrique et/ou électronique souple inclus dans le produit textile complexe.

4. Produit textile complexe selon l'une quelconque des revendications précédentes, **caractérisé en ce que** son épaisseur est comprise entre 0,3 mm et 5 mm, plus particulièrement entre 0,5 mm et 1 mm.

5. Produit textile complexe (6) selon la revendication 1, **caractérisé en ce qu'**il comporte en outre :
- des éléments de texturation (21) choisis parmi le groupe comportant des fils de laine, du tulle plié et recoupé, du voilage non tissé, des copeaux de bois, ou des particules de textile ;
- et/ou des éléments végétaux.

6. Produit textile complexe (6) selon la revendication 1, **caractérisé en ce que** la trame textile (5) imprégnée dans le matériau élastomère est un support textile choisi parmi le groupe comportant notamment : les textiles tissés, les textiles non-tissés, et les ouvrages textiles présentant des zones pleines et des zones ajourées disposées en motifs décoratifs du type dentelle.

7. Produit textile complexe (6) selon la revendication précédente, **caractérisé en ce que** la trame textile (5) est un assemblage de fibres textiles choisies parmi le groupe comportant notamment les fibres de verre, de silice, de métal, de céramique, de carbure de silicium, de carbone, d'aramide, de basalte, les fibres naturelles, les fibres cellulosiques, les fibres synthétiques, et leurs mélanges.

8. Procédé de fabrication de fabrication d'un produit textile complexe (6) du type comportant au moins une trame textile (5) qui est imprégnée dans un matériau élastomère de manière à être complètement revêtue du matériau élastomère sur ses deux faces, procédé comprenant les étapes suivantes :
0) dépôt, sur l'une au moins des faces de ladite trame textile (5), d'une composition (2') de résine, notamment élastomère, conductrice de l'électricité comportant des charges conductrices de l'électricité de manière à constituer au moins une piste souple conductrice de l'électricité incluse dans le produit textile complexe ;
A) application sur une surface plane de coulée (1) d'une composition fluide d'un matériau élastomère (2) pour former une couche (3) de matériau élastomère ;
B) dépôt, sur ladite couche (3) de matériau élastomère avant qu'elle ne se gélifie, de ladite trame textile (5) ;
C) raclage pour imprégner ladite trame textile (5) dans la couche (3) de matériau élastomère jusqu'à ce que les deux faces opposées de cette trame (5) soient complètement revêtues du matériau élastomère.

9. Procédé selon la revendication précédente, **caractérisé en ce qu'**il comporte l'étape supplémentaire suivante :
D) étuvage du produit textile (6) à une température comprise entre 50°C et 150°C.

10. Procédé selon l'une des revendications 8 ou 9, **caractérisé en ce que** l'étape 0) de dépôt est réalisée par extrusion, enduction, sérigraphie, ennoblissement, sérigraphie, flexographie ou à l'aide d'une imprimante numérique, notamment du type à jet d'encre.

11. Procédé selon l'une quelconque des revendications 8 à 10, **caractérisé en ce que** lesdites charges conductrices de l'électricité sont choisies parmi un groupe comportant notamment les poudres de charges métalliques et/ou minérales, la poudre de graphite de carbone, et les nanotubes de carbone.

12. Procédé selon l'une quelconque des revendications 8 à 11, **caractérisé en ce que** ladite étape 0) de dépôt consiste à former au moins une piste conductrice de l'électricité (31) avec deux extrémités (10) et (11), et **en ce que** le procédé comporte de plus une étape F) de raccordement de chacune des extrémités (10, 11) de ladite piste conductrice (31) à des fils électrique (12) par une soudure chimique, notamment à l'aide de la composition (2') de résine élastomère conductrice de l'électricité, et **en ce que** ledit matériau élastomère est non conducteur de l'électricité ou est isolé électriquement desdites charges conductrices de l'électricité.

13. Procédé selon l'une quelconque des revendications 8 à 12, **caractérisé en ce que**, préalablement à l'étape 0) de dépôt de la composition (2') de résine conductrice de l'électricité, au moins un composant électrique et/ou électronique est déposé sur ladite trame textile (5), et **en ce que** ladite composition (2') de résine élastomère conductrice de l'électricité est reliée électriquement audit composant pour constituer un élément de circuit électrique et/ou électronique souple inclus dans le produit textile complexe.

14. Procédé selon l'une quelconque des revendications 8 à 13, **caractérisé en ce que** la surface de coulée (1) est un tapis roulant, sur lequel est appliquée la composition fluide de matériau élastomère (2) de sorte que ledit procédé est continu.
